# EUROPEAN PATENT SPECIFICATION

(11) **EP 3 081 841 B1**
(45) Date of publication and mention of the grant of the patent: **07.03.2018**
(21) Application number: 16161893.9
(22) Date of filing: 23.03.2016
(51) Int. Cl.: F16M 13/02, G06F 1/16, H04N 5/64

(54) **DISPLAY APPARATUS**
ANZEIGEVORRICHTUNG
APPAREIL D'AFFICHAGE

(30) Priority: 16.04.2015 KR 20150053869
(43) Date of publication of application: 19.10.2016
(73) Proprietor: Samsung Electronics Co., Ltd., Gyeonggi-do 16677 (KR)
(72) Inventor: KIM, Jae-hyung, Gyeonggi-do (KR); YOON, Se-jin, Seoul (KR); CHUNG, Kang-il, Gyeonggi-do (KR)
(74) Representative: Hewett, Jonathan Michael Richard

(56) References cited:
- EP-A2- 2 503 211
- JP-A- 2010 226 648
- US-A1- 2009 095 869
- US-A1- 2010 086 145
- US-A1- 2012 075 783
- US-A1- 2012 268 867
- US-A1- 2015 053 497

## Description

The present invention relates to a display apparatus, and more particularly, to a display apparatus including a stand which performs a stand function in a stand mode and performs a sound reflector function in a wall mount mode.

The display apparatuses may be apparatuses which display visual image information and transmit auditory information. In recent years, the display apparatuses, which have less installation space restraints through reduction in weight and volume which are disadvantages in cathode-ray tubes, are easy to implement a large-scaled image and a flat panel, and have various good performances such as high quality, have been developed.

The display apparatuses in the related art may have disadvantages of a large overall size with respect to the gross area, heavy weight, and cumbersome handling. However, in recent years, the display apparatuses which are installed on a wall or in a stand form are emerging due to a thin thickness and light weight.

In general, the display apparatuses which employ thin display panels such as an organic light emitting diode (OLED), a plasma display panel (PDP), or a liquid crystal display (LCD) may realize a large-scaled screen, provide high image quality, and minimize an installation space, and thus the display apparatuses employing the thin displays are drawing attention as substitutes for existing CRT type or projection type display apparatuses.

Such display apparatuses may be installed in a wall mount mode or a stand mode. In response to the display apparatus being installed in the wall mount mode, the display apparatus may be used by fixing a bracket for installation to a wall, and mounting the display apparatus on the bracket. In response to the display apparatus being used in the stand mode, the display apparatus may be supported by a stand unit.

However, unlike the stand mode, in response to the wall mount mode that the display apparatus is installed on a wall, transmitted force of middle tone/high tone may be reduced due to increase in a distance between a speaker and a reflecting surface of sound output from the speaker in the existing apparatuses. Thus, viewers located in a front of the display apparatus in the wall mount mode may need to increase volume as compared with the stand mode.

The stand which supports the display apparatus in the stand mode may not be used in the wall mount mode, and in response to the stand being separated from the display apparatus and kept, the stand may be damaged or lost.

In the existing display apparatuses, the stand having an inclined surface may be disposed below a speaker and serve as a sound reflector. However, the stand may be fixed to a display main body, and thus conversion to a wall mount mode may be difficult. In response to the display apparatus having the stand being hung on a wall, the display apparatus needs to be spaced from the wall by a significant distance due to a thickness of the stand having the slope surface. Thus, the display apparatuses may be structurally unstable and may further require additional members for structural stability. The stand having the slope may be difficult to be applied to the display apparatuses due to the large bulk and clumsy shape in terms of design.

The conversion from the stand mode to the wall mount mode or from the wall mount mode to the stand mode may not be easy in the existing display apparatuses, and thus the existing display apparatuses may not meet the demands of the viewers to view an image from the display apparatuses in an optimum environment.

US2010/086145A1 relates to a sound speaker system for thin equipment such as LCD and plasma TVs, having a separate passive radiator.

EP2503211A1 relates to a flat display device with a supporting base.

One or more exemplary embodiments of the present invention relate to a display apparatus including a stand, which supports the display apparatus in a stand mode and serves as a sound reflector for reflecting sound in a wall mount mode, and capable of mutual mode conversion between the stand mode and the wall mount mode.

According to an aspect of the present invention, there is provided a display apparatus according to claim 1.

According to an aspect of an exemplary embodiment, there is provided a display apparatus including a display main body of which at least one sound output unit is disposed in a lower end; a fixing unit separately coupled to a rear surface of the display main body; and a stand unit of which a posture is changed according to a stand mode and a wall mount mode with respect to the display main body. The stand unit may support the display main body with respect to a ground in the stand mode, and may guide sound output from the sound output unit to a front of the display main body in the wall mount mode.

A lower portion of the stand unit may be disposed to be downwardly tilted in the wall mount mode. The stand unit may be coupled to the fixing unit in the stand mode, and may be coupled to the display main body in the wall mount mode. The stand unit may include a pillar part of which one end is separately coupled to the fixing unit or the display main body; and a plate-shaped supporting part formed to extend from the other end of the pillar part. The supporting part may be disposed in parallel to the lower end of the display main body. The pillar part may include a first coupling part and a second coupling part separately coupled to the fixing unit or a portion of the display main body. One of the first coupling part and the second coupling part may have a protrusion
shape and the other thereof may have a groove shape.

A plurality of first coupling parts and a plurality of second coupling parts may be provided.

The fixing unit or the display main body may include a third coupling part and a fourth coupling part coupled to the first coupling part and the second coupling part.

The pillar part may be coupled to the display main body through a plurality of screws.

The stand unit may further include a first extension part and a second extension part extending from both sides of the supporting part. The first extension part and the second extension part may be bent or curved to collect the sound output from the sound output unit to a front of the display main body in the wall mount mode.

The first and second extension parts may have lengths 0.05 to 0.2 times a length of the stand unit.

The fixing unit may further include a coupling part fixed to a wall in the wall mount mode.

The fixing unit may protrude from the rear surface of the display main body rather than the stand unit so that the stand unit is spaced from a wall in the wall mount mode.

An upper portion of the stand unit may be rotatably hinge-coupled to the display main body.

The stand unit may be fixed and supported by the fixing unit in a non-rotation state in the stand mode.

The display apparatus may further include an elastic stopper which gets into and gets out of a surface facing the pillar part of the stand unit in a lower portion of the display main body by a spring; and a fixing groove formed in a surface of the pillar part facing the lower portion of the display main body and corresponding to a shape of the elastic stopper.

The fixing unit may be separately coupled to a lower portion of the rear surface of the display main body in the stand mode, and may be separately coupled to an upper portion of the rear surface of the display main body in the wall mount mode.

According to an aspect of an exemplary embodiment, there is provided a display apparatus including a display main body of which at least one sound output unit is disposed in a lower end; a fixing unit separately coupled to the display main body; and a stand unit configured to indirectly support the display main body through the fixing unit. The stand unit may be coupled to the display main body by the fixing unit and support the display main body with respect to a ground in a stand mode, and the stand unit may be fixed to the display main body at a preset angle and guide sound output from the sound output unit to a front of the display main body in a wall mount mode.

According to an aspect of an exemplary embodiment, there is provided a display apparatus including a display main body of which at least one sound output unit is disposed in a lower end; a fixing unit separately coupled to the display main body; and a stand unit configured to directly support the display main body and rotatably hinge-coupled to the display main body. The stand unit may be fixed to the display main body by the fixing unit and support the display main body with respect to a ground in a stand mode, and the stand unit may be rotated at a preset angle and guide sound output from the sound output unit to a front of the display main body in a wall mount mode.

Additional aspects and advantages of the exemplary embodiments are set forth in the detailed description, and will be obvious from the detailed description, or may be learned by practicing the exemplary embodiments.

The above and/or other aspects of the present invention will be more apparent by describing certain exemplary embodiments of the present invention with reference to the accompanying drawings, in which:
FIG. 1 is a front view illustrating a display apparatus in a stand mode according to a first exemplary embodiment;
FIG. 2 is a rear view illustrating a display apparatus in a stand mode according to the first exemplary embodiment;
FIG. 3 is a side view illustrating a display apparatus in a stand mode according to the first exemplary embodiment;
FIG. 4 is a perspective view illustrating a stand unit according to the first exemplary embodiment;
FIG. 5 is an exploded perspective view illustrating a coupling structure of a stand unit according to the first exemplary embodiment;
FIG. 6 is a lateral cross-sectional diagram illustrating an A portion of FIG. 3;
FIG. 7 is a front view illustrating a display apparatus in a wall mount mode according to the first exemplary embodiment;
FIG. 8 is a rear view illustrating a display apparatus in a wall mount mode according to the first exemplary embodiment;
FIG. 9 is a side view illustrating a display apparatus in a wall mount mode according to the first exemplary embodiment;
FIG. 10 is a perspective view illustrating a coupling portion of a stand unit in a wall mount mode according to the first exemplary embodiment;
FIG. 11 is an exploded perspective view illustrating a coupling portion of the fixing unit in a wall mount mode according to the first exemplary embodiment;
FIG. 12 is a front view illustrating a display apparatus in a stand mode according to a second exemplary embodiment;
FIG. 13 is a side view illustrating a display apparatus in a stand mode according to the second exemplary embodiment;
FIG. 14 is a front view illustrating a display apparatus in a wall mount mode according to the second exemplary embodiment;
FIG. 15 is a side view illustrating a display apparatus in a wall mount mode according to the second exemplary embodiment;
FIG. 16 is a side view illustrating a display apparatus in a stand mode according to a third exemplary embodiment;
FIG. 17 is a schematic diagram illustrating a display apparatus that a fixing unit is removed in a stand mode according to the third exemplary embodiment;
FIG. 18 is a side view illustrating a display apparatus in a wall mount mode in a wall mount mode according to the third exemplary embodiment;
FIG. 19 is a schematic diagram illustrating a method of controlling a rotation angle of a hinge unit as a B portion of FIG. 18; and
FIG. 20 is a schematic diagram illustrating a C portion of FIG. 19.

Hereinafter, the exemplary embodiments are described in greater detail with reference to the accompanying drawings.

In the following description, unless otherwise described, the same reference numerals are used for the same elements when they are depicted in different drawings. The matters defined in the description, such as detailed construction and elements, are provided to assist in a comprehensive understanding of exemplary embodiments. Thus, it is understood that the exemplary embodiments may be carried out without those specifically defined matters. Also, functions or elements known in the related art are not described in detail since they would obscure the exemplary embodiments with unnecessary detail.

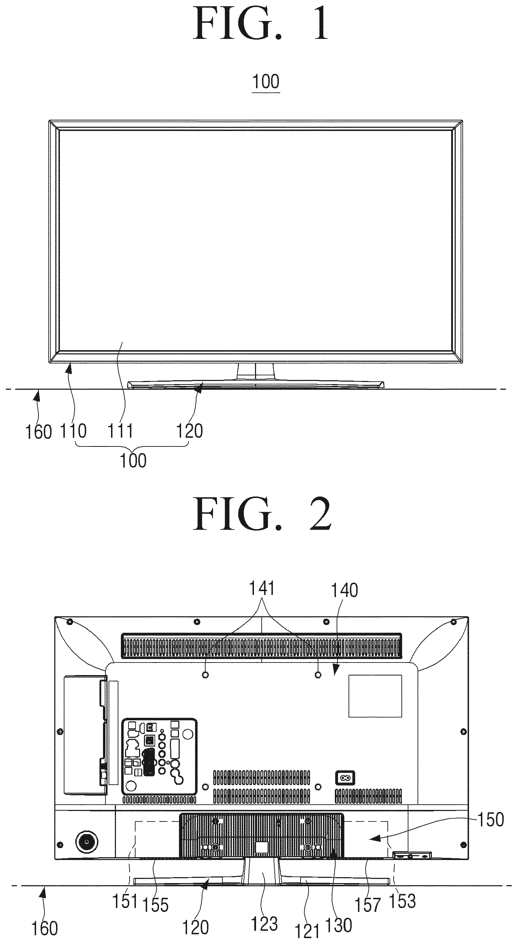

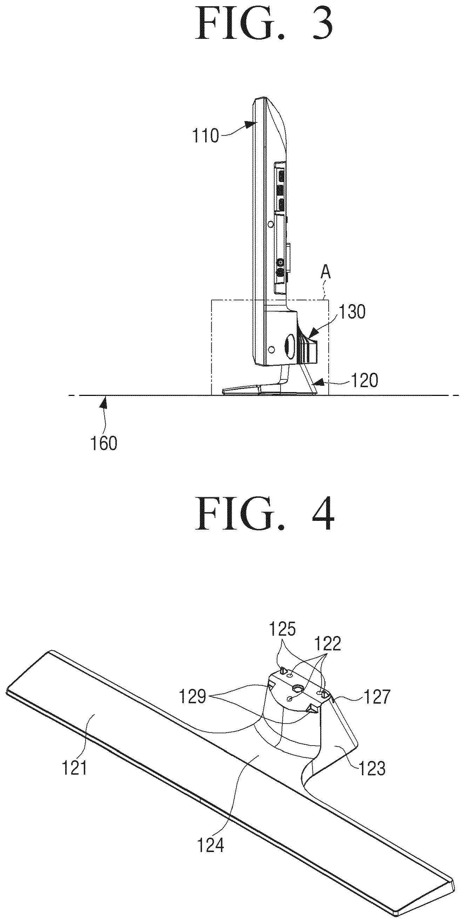

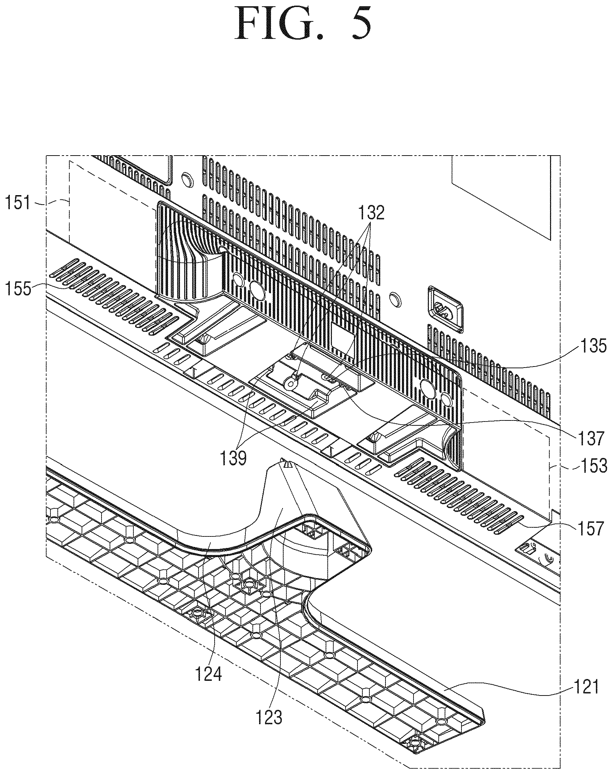

Hereinafter, a display apparatus in a stand mode according to an exemplary embodiment will be described with reference to FIGS. 1 to 6.

The display apparatus 100 in the stand mode may include a display main body 110, a stand unit 120, a fixing unit 130, a mount unit 140, and a sound output unit 150.

The display apparatus 100 includes a display 111 which may be configured to output image information. The display 111 may have a quadrangular shape, and occupy most of a front surface of the display apparatus 100. The stand unit 120 may be located below the display 111.

The stand unit 120 may be coupled to a lower portion of the display main body 110 to support the display main body 110. The stand unit 120 may include a supporting part 121, at least one first screw coupling part 122, a pillar part 123, at least one first coupling part 125, and at least one second coupling part 127 and 129.

The supporting part 121 may distribute weight of the display main body 110 to a supporter 160 and support the weight of the display main body 110. The supporting part 121 may support the display main body with respect to the supporter 160 with the structure stability. The supporting part 121 may be coupled to the pillar part 123 through a connection part 124. The supporting part 121 may be disposed in parallel to the lower end of the display main body 110.

The supporting part 121 may be formed in a rectangular plate-like shape to stably support the weight of the display main body 110. According to such a shape of the supporting part 121, the stand unit 120 may generally have a T shape through the supporting part 121 formed in a plate shape, the connection part 124, and the pillar part 123. The supporting part 121 may be in contact with the supporter 160 in a top of the supporter 160 with a certain area by the T shape, and stably support the display main body 110.

The supporting part 121 may serve to reflect sound output from speakers 151 and 153 together with the supporter 160.

A plurality of first screw coupling parts 122 may be disposed in a top of the pillar part 123. The first screw coupling partsi22 may fix the stand unit 120 to the fixing unit 130 or the display main body 110 together with the first and second coupling parts 125, 127, and 129.

One end of the pillar part 123 may be separably coupled to the fixing unit 130 or the display main body 110. The one end of the pillar part 123 may include the first coupling part 125, the second coupling parts 127 and 129, and the first screw coupling parts 122 so as to be coupled to the display main body 110. The other end of the pillar part 123 may be coupled to the supporting part 121 through the connection part 124.

The pillar part 123 may be configured in a stub column form free from bucking so as to stably support the weight of the display main body 110. The pillar part 123 may be formed of a plastic material. The pillar part 123 may be formed to have a thin hollow section for screw coupling with the fixing unit 130 or the display main body 110. Accordingly, the operator may couple the pillar part 123 to the fixing unit 130 or the display main body 110 using a screw (not shown). A front surface of the pillar part 123 may be formed in a cylindrical shape and a rear surface of the pillar part 123 may be formed in a rectangular parallelepiped shape.

The first coupling part 125 may allow the pillar part 123 to be coupled to the fixing unit 130 or the display main body 110. The first coupling part 125 may be formed in a protrusion shape. A plurality of first coupling parts 125 may be formed.

In the stand mode, the fixing unit 130 may include a third coupling part 135 corresponding to the first coupling part 125.

In the wall mount mode, a display main body 110a may include a third coupling part 115a corresponding to the first coupling part 125.

The second coupling parts 127 and 129 may allow the pillar part 123 to be coupled to the fixing unit 130 or the display main body 110 like the first coupling part 125. The second coupling parts 127 and 129 may be formed in a groove shape. A plurality of second coupling parts 127 and 129 may be formed.

In the stand mode, the fixing unit 130 may include fourth coupling parts 137 and 139 corresponding to the second coupling parts 127 and 129.

In the wall mount mode, the display main body 110a may include a fourth coupling part 119a corresponding to a second coupling part 127, 129.

In the stand mode, a plurality of second screw parts 132 may be formed in a lower portion of the fixing unit 130 to correspond to the first screw coupling part 122 of the pillar part 123.

In the wall mount mode, a fixing unit 130a may be separated from the display main body 110a. A pillar part 123 may be coupled to a portion of the display main body 110a from which the fixing unit 130a is separated.

The fixing unit 130 may be configured to fix and support the stand unit 120 in a lower portion of the rear surface of the display main body 110. The fixing unit 130 may include the second screw coupling part 132, the third coupling part 135, and the fourth coupling parts 137 and 139.

The fixing unit 130 may be separably coupled to the rear surface of the display main body 110. The fixing unit 130 may be coupled to the rear surface of the display main body 110. The stand unit 120 may be coupled to the fixing unit 130 which is fixed and coupled to the display main body 110.

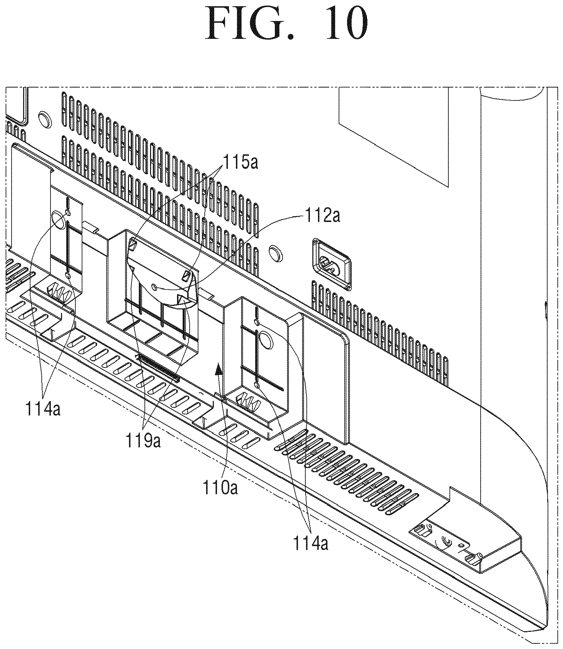

FIG. 10 illustrates the display apparatus that the fixing unit 130a is separated from the display main body 110a so as to realize the wall mount mode. In the stand mode, the fixing unit 130 may include a plurality of screw coupling grooves 114a to be coupled to the display main body 110.

The second screw coupling part 132 may be formed to face the first screw coupling part 122 of the stand unit 120 in the stand mode. Accordingly, a plurality of screws (not shown) may pass through the first and second screw coupling parts 122 and 132 and couple the stand unit 120 and the fixing unit 130.

The third coupling part 135 may be formed to correspond to the first coupling part 125 of the stand unit 120 in the stand mode. The third coupling part 135 may be formed in the groove shape to correspond to the first coupling part 125 having the protrusion shape.

The fourth coupling parts 137 and 139 may be formed to correspond to the second coupling parts 127 and 129 of the stand unit 120 in the stand mode. The fourth coupling parts 137 and 139 may be formed in a protrusion shape to correspond to the shapes of the second coupling parts 127 and 129 having the groove shape.

In the wall mount mode, the fixing unit 130a may be coupled to the mount unit 140a and coupled to a bracket 191 located on a wall 190. Accordingly, the fixing unit 130a may fix and support the display main body 110a to the wall 190.

The mount unit 140 may be coupled to the wall 190 in the wall mount mode of the display apparatus 100. The mount unit 140 may include a fastener 141, to which the fixing unit 130a is coupled in the wall mount mode, in an upper central portion thereof.

The sound output unit 150 may include the speakers 151 and 153 disposed in the lower portion of the display main body 110. The speakers 151 and 153 may be disposed at both sides of the fixing unit 130 to which the stand unit 120 is coupled. Openings 155 and 157, which allow the sounds of the speakers 151 and 153 to be output, may be installed below the speakers 151 and 153.

In the stand mode, the sounds which are output from the speakers 151 and 153 and pass through the openings 155 and 157 may be reflected by the supporting part 121 or the supporter 160 and directed to the front of the display main body 110.

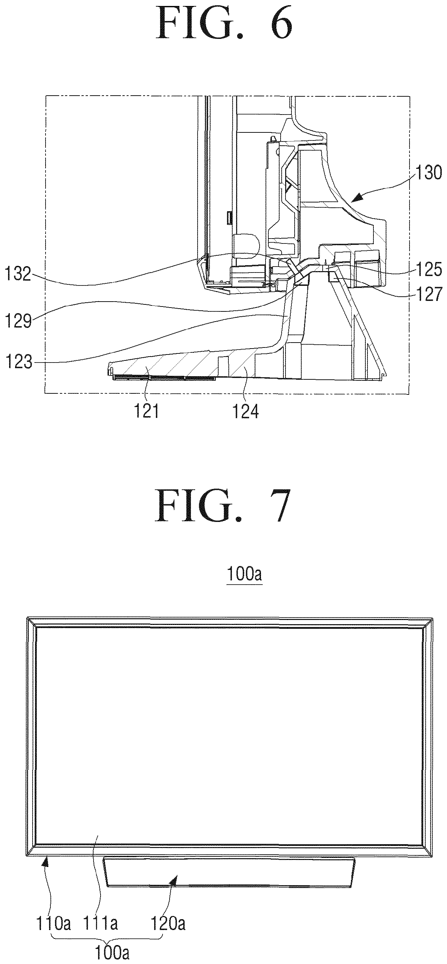

A display apparatus 100a in the wall mount mode according to the first exemplary embodiment will be described with reference to FIGS. 7 to 11. The display apparatus 100a in the wall mount mode may mostly have the same configuration as the display apparatus 100 in the wall mount mode, but configurations of the stand unit 120a and the fixing unit 130a in the wall mount mode of display apparatus 100a may be different from those of the stand unit 120 and the fixing unit 130 in the stand mode of display apparatus 100. The same numbers refer to the same elements in the wall mount mode of display apparatus 100a as those in the stand mode of display apparatus 100, and description for the same configurations as those in the stand mode of display apparatus 100 will be omitted.

The display apparatus 100a may be the same as the display apparatus 100, the display main body 110a may be the same member as the display main body 110, and the stand unit 120a may be the same member as the stand unit 120. The fixing unit 130a may be the same member as the fixing member 130, the mount unit 140a may be the same member as the mount unit 140, and the sound output unit 150a may be the same member as the sound output unit 150. However, since the arrangement of members may be changed according to conversion from the stand mode to the wall mount mode, different numbers refer to the same numbers for clarity.

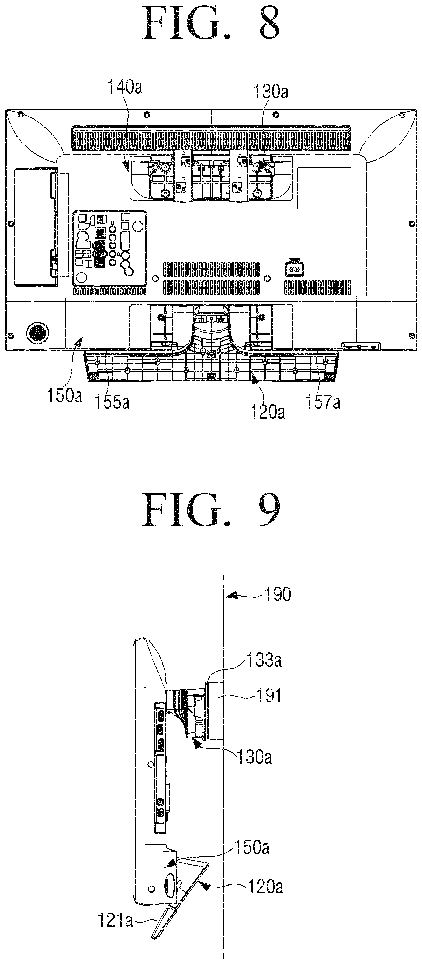

Referring to FIGS. 7 and 9, the wall mount mode of display apparatus 100a may be fixed and supported to the wall 190. The stand unit 120a may be obliquely coupled to the display main body 110a in the wall mount mode. Referring to FIG. 9, sound waves output through openings 155a and 157a of the sound output unit 150a may be reflected by the supporting part 121a obliquely formed, and guided or reflected to the front of the display main body 110a in which a viewer is located. The exemplary embodiment has illustrated that the stand unit 120a may be obliquely coupled to the display main body 110a, but the stand unit 120a may be vertically coupled to the display main body 110a.

For example, the stand unit 120 in the stand mode may serve to support the display main body 110, and the stand unit 120a in the wall mount mode may serve as a sound reflector. Through such a structure, the stand unit 120 and 120a may be used in the stand mode and the wall mount mode, and thus the risk of damage or loss may be eliminated while the stand unit 120a is kept.

Referring to FIG. 10, the stand unit 120a may be coupled to the display main body 110a. The first coupling part 125 formed in the top of the pillar part 123 may be coupled to the third coupling part 115a. The second coupling part 127 and 129 may be coupled to the fourth coupling part 119a. One of the first screw coupling parts 122 may face a third screw coupling part 112a to allow a screw (not shown) to pass through the one of the first screw coupling parts 122.

Through the configuration, the stand unit 120a may be obliquely coupled to the display main body 110a.

The fixing unit 130a may be separated from the lower portion of the display main body 110a and coupled to the mount unit 140a in the wall mount mode. The fixing unit 130a may be inversely coupled to the mount unit 140a with respect to a direction coupled in the stand mode. The fixing unit 130a may be coupled to the fastener 141 of the stand mode.

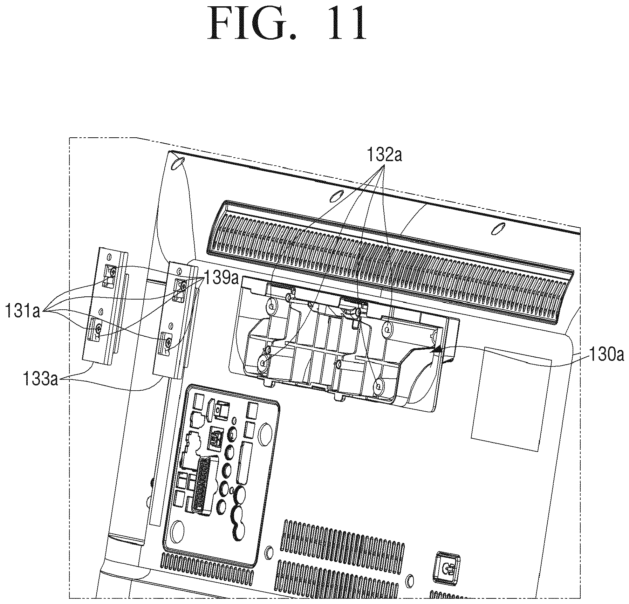

It can be seen from FIG. 11 that a coupling part 133a may be coupled to the fixing unit 130a fixed and coupled to the mount unit 140a. Screw holes 132a to which a plurality of coupling part 133a are coupled may be provided in the fixing unit 130a. A plurality of fasteners such as screws 131a coupled to the screw holes 132a may be formed in the coupling part 133a. A plurality of bracket coupling grooves 139a may be provided in the coupling parts 133a to be coupled to the bracket 191 located on the wall 190.

FIG. 9 illustrates the stand unit 120a coupled to the display main body 110a and the fixing unit 130a coupled to the wall 190 in the wall mount mode. The fixing unit 130a may be formed to protrude from the rear surface of the display main body 110a rather than the stand unit 120a so that the stand unit 120a may be spaced from the wall 190 in the wall mount mode.

The first exemplary embodiment has described that the display apparatus 100 and 100a includes the fixing unit 130 and 130a. In another example, the stand unit 120 may be fixed and coupled to the display main body 110 without the fixing unit 130 in the stand mode, and the stand unit 120a may be obliquely coupled to the display main body 110a in the wall mount mode.

Hereinafter, an operation of the display apparatus 100 and 100a having the above-described configuration according to the first exemplary embodiment will be described in detail.

In the stand mode as illustrated in FIGS. 1 to 6, the stand unit 120 may support the display main body 110 with respect the supporter 160. The stand unit 120 may be fixed and coupled to the fixing unit 130. The fixing unit 130 may be fixed and coupled to the rear surface of the display main body 110.

The sound output unit 150 may be located in the lower portion of the display main body 110. Sound may be output from the sound output unit 150, reflected by the supporter 160, and guided to the viewer in front of the display main body 110.

In the wall mount mode as illustrated in FIGS. 7 to 11, the stand unit 120a may be separated from the fixing unit 130a. The fixing unit 130a may also be separated from the display main body 110a. The separated fixing unit 130a may be coupled to the mount unit 140a. The stand unit 120a may be coupled to the display main body 110a from which the fixing unit 130a be separated.

The stand unit 120a may be obliquely coupled to the display main body 110a and may guide the sound output from the sound output unit 150a to the front of the display main body 110a. The stand unit 120a may be vertically coupled to the display main body 110a.

The fixing unit 130a coupled to the mount unit 140a may be fixed and supported to the bracket 191 of the wall 190 by the coupling part 133a. The fixing unit 130a may be formed to protrude from the rear surface of the display main body 110a rather than the stand unit 120a so that the stand unit 120a may be spaced from the wall.

The conversion from the wall mount mode to the stand mode may be inversely performed with respect to the conversion mode from the stand mode to the wall mount mode. That is, the mount unit 140a fixed and supported to the bracket 191 of the wall 190 may be separated from the bracket 191, and the fixing unit 130a coupled to the mount unit 140a may be separated from the mount unit 140a. The stand unit 120a may be separated from the display main body 110a, and the fixing unit 130a may be coupled to the display main body 110a. The stand unit 120a may be coupled to the fixing unit 130a, and thus the display apparatus 100 and 100a may be operated as the stand mode.

As described above, the conversion from the stand mode to the wall mount mode or from the wall mount mode to the stand mode may be easily performed. Thus, the stand unit may be easily changed as a dual mode of the stand mode and the wall mount mode, and the stand unit may easily perform the functions as a supporter for the display main body and a sound reflector according to the use purpose. Accordingly, the display apparatus may meet the demand of the viewer to view the display apparatus with optimum sound in an optimum height and an optimum viewing zone.

The stand unit in the exemplary embodiment may perform the stand function and the sound reflector function and simultaneously have a thin "T" shape good in terms of design other than the large bulk and clumsy shape. Accordingly, the stand unit may be easily mounted at a certain angle within a distance spaced between the wall and the display main body in the wall mount mode without the interference with the wall. The stand unit may improve the sense of beauty in the display apparatus and simultaneously improve the sense of an interior in a space in which the display apparatus is located.

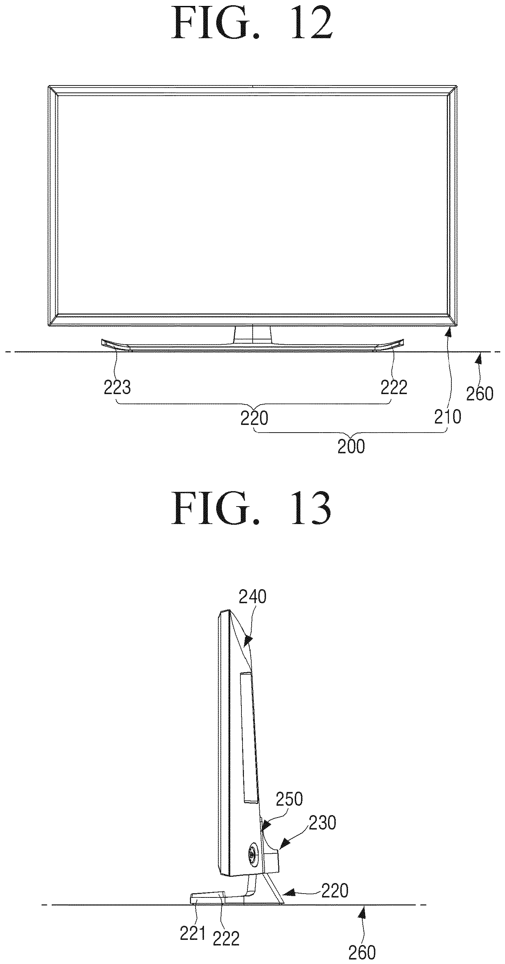

A display apparatus 200 and 200a according to a second exemplary embodiment will be described with reference to FIGS. 12 to 15. The display apparatus 200 and 200a according to the second exemplary embodiment mostly may have the same configuration as the display apparatus 100 and 100a according to the first exemplary embodiment, but a configuration of a stand unit 220 and 220a may be different from that of the stand unit 120 and 120a. The same numbers refer to the same elements in the display apparatus 200 and 200a according to the second exemplary embodiment as those in the display apparatus 100 and 100a according to the first exemplary embodiment, and description for the same configurations as those in the display apparatus 100 and 100a will be omitted.

Referring to FIGS. 12 and 13, the display main body 210 may be supported by the stand unit 220 in the stand mode. A shape of the supporting part 221 in the second exemplary embodiment may be different from the shape of the supporting part 121 in the first exemplary embodiment. That is, the stand unit 220 may include first and second extension parts 222 and 223 extending from both sides of the supporting part 221. The supporting part 221 may be in contact with a supporter 260 and support the display main body 210 in the stand mode. However, the first and second extension parts 222 and 223 may be spaced from the supporter 260 toward end portion thereof to form a certain height.

The display apparatus 200a may be the same as the display apparatus 200, the display main body 210a may be the same member as the display main body 210, and the stand unit 220a may be the same member as the stand unit 220. A fixing unit 230a may be the same member as a fixing member 230, a mount unit 240a may be the same member as a mount unit 240, and a sound output unit 250a may be the same member as a sound output unit 250. However, since the arrangement of members may be changed according to conversion from the stand mode to the wall mount mode, different numbers refer to the same numbers for clarity.

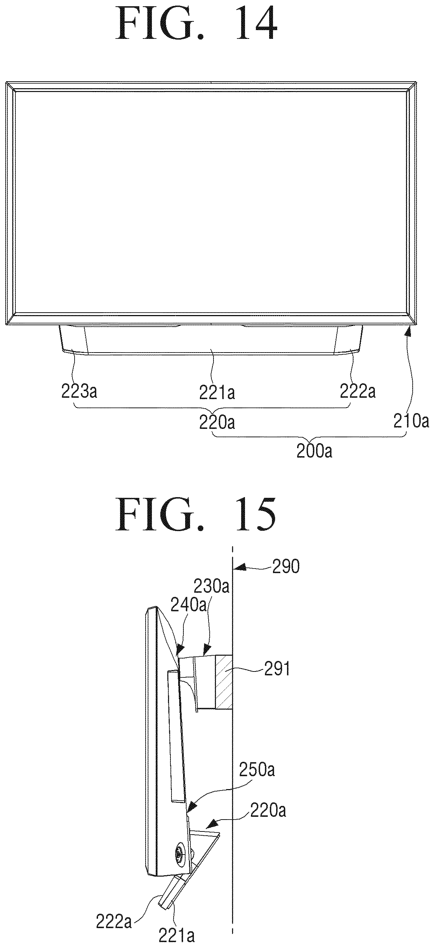

Referring to FIGS. 14 and 15, the first and second extension parts 222 and 223 may be bent or curved to a front of the display main body 210a so as to collect or reflect sound output from the sound output unit 250a to the front of the display main body 210a in the wall mount mode. The term "curved" may refer to that the first and second extension parts 222a and 223a, which extend from both ends of the supporting part 221a, are curved in an arc shape to the front of the display main body 210a toward the ends thereof in the wall mount mode. The term "bent" may refer to that the first and second extension parts 222a and 223a, which extend from both ends of the supporting part 221a, are bent at both ends of the supporting part 221a and ends of the first and second extension parts 222a and 223a protrude to the front of the display main body 210a.

The first and second extension parts 222a and 223a may be formed in a circular arc shape. The phrase "circular arc shape" may refer to that the first and second extension parts 222a and 223a are formed in a shape curved to the front of the display main body 210a toward the ends thereof without sharp change of a surface at a point that the supporting part 221a meets the first and second extension parts 222a and 223a.

Through the shapes of the first and second extension parts 222a and 223a, the stand unit 220a may further concentrate the sound to the front of the display main body 210a, and thus the viewer may listen to high-quality sound.

In the second exemplary embodiment, the first and second extension parts 222 and 223 and 222a and 223a may be formed to have a length about 0.05 to 0.2 times a length of the stand unit 220 and 220a. However, the first and second extension parts 222 and 223 and 222a and 223a may be formed to have the length about 0.2 or more times the length of the stand unit 220 and 220a.

An operation of the display apparatus 200 and 200a according to the second exemplary embodiment having the above-described configuration is the same as that of the display apparatus 100 and 100a according to the first exemplary embodiment, and thus detailed description thereof will be omitted.

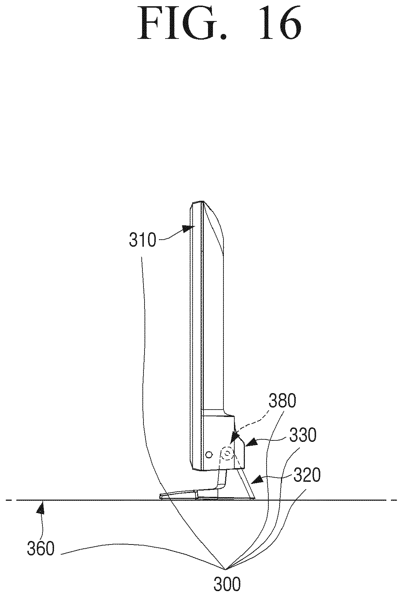

A display apparatus 300 and 300a according to a third exemplary embodiment will be described with reference to FIGS. 16 to 20. The display apparatus 300 and 300a according to the third exemplary embodiment may mostly have the same configuration as the display apparatus 100 and 100a according to the first exemplary embodiment, but a configuration of a stand unit 320 and 220a may be different from that of the stand unit 120 and 120a in that the stand unit 320 and 320a may be pivotably installed by a hinge part 380 and 380a. The same numbers refer to the same elements in the display apparatus 300 and 300a according to the third exemplary embodiment as those in the display apparatus 100 and 100a according to the first exemplary embodiment, and description for the same configurations as those in the display apparatus 100 and 100a according to the first exemplary embodiment will be omitted.

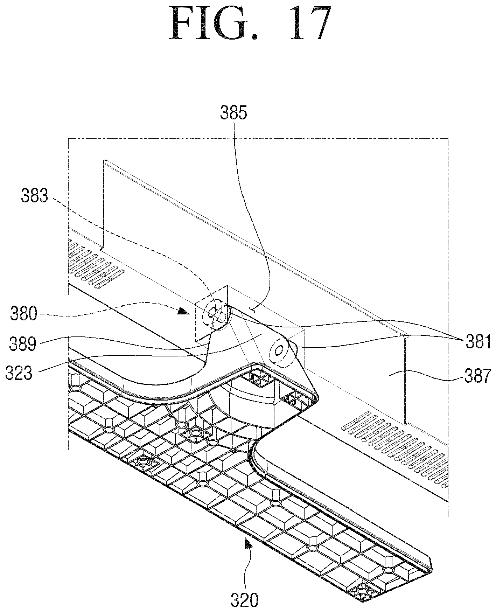

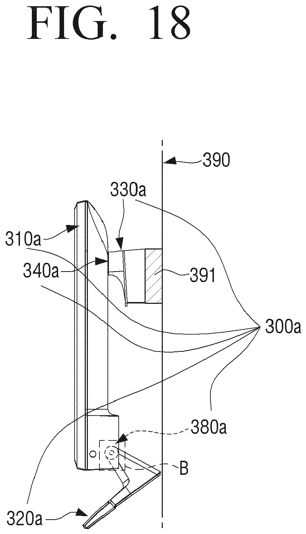

FIG. 16 is a side view illustrating a stand mode of display apparatus according to the third exemplary embodiment, FIG. 17 is a schematic diagram illustrating the display apparatus from which a fixing unit is removed in the stand mode according to the third exemplary embodiment, and FIG. 18 is a side view illustrating a wall mount mode of display apparatus according to the third exemplary embodiment.

Referring to FIGS. 16 and 17, a display main body may be supported by the stand unit 320 in the stand mode. The third exemplary may be different from the first and second exemplary embodiments in that the stand unit 320 includes a pillar part 323 rotatably coupled to the display main body 310.

The stand unit 320 may be rotatably coupled to the display main body 310 by a hinge unit 380 formed in a rear lower portion 387 of the display main body 310.

The hinge unit 380 may include a hinge shaft container 381 and a hinge shaft 383. The hinge shaft container 381 may be formed in both sides of a pivot groove 385 formed in the rear lower portion 387 of the display main body 310 and may support the hinge shaft 383. The hinge shaft 383 may be configured to couple the hinge shaft container 381 and the pillar part 323, and the hinge shaft 383 may be formed to pass through an upper portion of the pillar part 323. The pivot groove 385 may be formed to be pivoted without the interference with the display main body 310.

A stand unit 320a may be fixed to a hinge unit 380a at a certain angle through a locking structure in the wall mount mode as illustrated in FIG. 18. The locking structure may include a fixing groove (not shown), which is formed in the pillar part 323a of the stand unit 320a coupled to the hinge unit 380a, and an elastic protrusion (not shown) which is formed in an inner side of the hinge unit 380a or an inner side of the pivot groove 385a and is elastically coupled to the fixing groove.

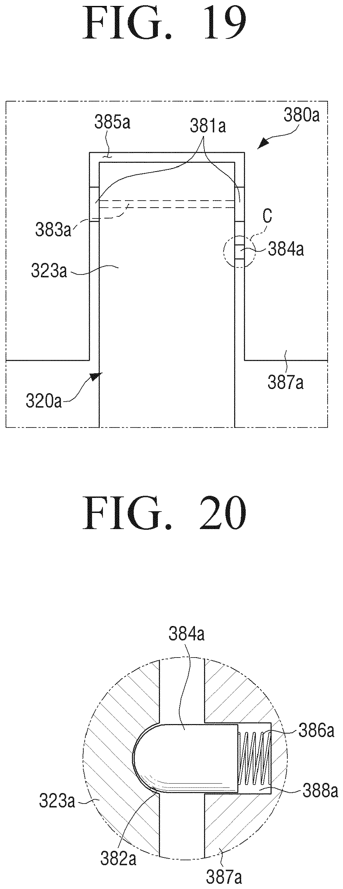

A rotation range of the hinge unit 380a may be determined to various angles through a multistage rotation structure in the wall mount mode by controlling a forming angle through the stand unit 320a as illustrated in FIGS. 19 and 20 which are an enlarged diagram for B portions of FIG. 18.

Referring to FIGS. 19 and 20, an elastic stopper 384a, which is capable of getting into and out of a surface of a rotation angle control groove 388a facing the pillar part 323a located in a rear lower portion 387a of the display main body 310a, that is, one side of the pivot groove 385a by an elastic member such as a spring 386a, may be placed, and a fixing groove 382a corresponding to a shape of the elastic stopper 384a may be formed in a surface of the pillar part 323a facing the rotation angle control groove 388a. Thus, the forming angle may be controlled during the rotation of the pillar part 323a and the sense of detachment may be provided.

In order for the elastic stopper 384a to get into and get out of the surface of the rotation angle control groove 388a facing the pillar part 323a by the spring 386a, a groove (not shown) may be provided in a certain position of the rotation angle control groove 388a, the spring 386a and a supporting body (not shown) configured to support the elastic stopper 384a may be placed in the groove, and the elastic stopper 384a may be placed on the supporting body. Thus, the elastic stopper 384a may get into and get out of the surface facing the pillar part 323a. The exemplary embodiment has illustrated that the elastic stopper 384a of which one end has a semispherical shape is a cylinder. However, the elastic stopper 384a may have various shapes such as a metallic bead or a conical shape having a smooth and tapered end.

Through the configuration of the elastic stopper 384a and the fixing groove 382a, the pillar part 323a may allow the stand unit 320a to be rotated with respect to the display main body 310a by controlling the rotation angle of the stand unit 320a in a multistage in response to the pillar part 323a being rotated. For example, the multistage may be configured of five stages. In this example, a first stage may refer to that the pillar part 323a is vertically located with respect to a supporter 360, and a fifth stage may refer to that the pillar part 323a is rotated to a rear of the display main body 310a by about 90 degrees from the first stage and disposed in parallel to the supporter 360. Accordingly, the viewer may enjoy the optimum sound by controlling a rotation angle of the stand unit 320a suitable for the viewer.

In the third exemplary embodiment, in response to a bottom surface of the stand unit 320 is supported by the supporter 360 in the stand mode, a front surface of the pillar part 323 in the stand unit 320 may be in contact with a pivot preventing bump 389. The pivot preventing bump 389 prevents an overrotation of the pillar part 323 and support the pillar part 323 so that the stand unit 320 stably supports the display main body 310. The fixing unit 330 may support the stand unit 320 in such a manner that the fixing unit 330 surrounds the stand unit 320 and the rear lower portion 387 of the display main body 310 in the stand mode.

Through the configuration, the pillar part 323 of the stand unit 320 is supported by the pivot preventing bump 389 and the fixing unit 330 in the stand mode, and thus the stand unit 320 may structurally stably support the display main body 310.

The configuration of the display apparatus in the wall mount mode according to the third exemplary embodiment is the same as those of the display apparatuses in the wall mount mode according to the first and second exemplary embodiments, and thus detailed description thereof will be omitted.

An operation of the display apparatus 300 and 300a having the above-described configuration according to the third exemplary embodiment is mostly the same as that of the display apparatus 100 and 100a according to the first exemplary embodiment, and thus detailed description thereof will be omitted.

The operation of the stand unit 320 and 320a in the mode conversion from the stand mode to the wall mount mode or from the wall mount mode to the stand mode in the display apparatus according to the third exemplary embodiment is different from that in the display apparatus according to the first exemplary embodiment. That is, the stand unit 320 and 320a may be rotatably supported by the hinge unit 380 and thus may not be separated from the display main body 310 and 310a in the mode conversion. Accordingly, the mode conversion in the third exemplary embodiment may be simpler than those in the first and second exemplary embodiments.

The foregoing exemplary embodiments and advantages are merely exemplary and are not to be construed as limiting the present invention. The present teaching can be readily applied to other types of apparatuses. Also, the description of the exemplary embodiments of the present invention is intended to be illustrative, and not to limit the scope of the claims, and many alternatives, modifications, and variations will be apparent to those skilled in the art.

## Claims

1. A display apparatus comprising:
a display main body (no);
at least one sound output unit (150) disposed in a lower portion of the display main body (110);
a fixing unit (130) separably coupled to a rear surface of the display main body (110); and
a stand unit (120), the posture of the stand unit (120) being changeable according to one of a stand mode and a wall mount mode of the display apparatus with respect to the display main body (110),
wherein the stand unit (120) is arranged to support the display main body (110) with respect to the ground in the stand mode, and **characterized in that**, the stand unit (120) is disposed below the sound output unit (150) and is arranged to be downwardly tilted towards a front of the display main body (110) to reflect sound output from the sound output unit (150) to the front of the display main body (110) in the wall mount mode.

2. The display apparatus as claimed in claim 1, wherein the stand unit is coupled to the fixing unit when the display apparatus is in the stand mode, and is coupled to the display main body when the display apparatus is in the wall mount mode.

3. The display apparatus as claimed in claim 2, wherein the stand unit (120) includes:
a pillar part (123) of which one end is separately coupled to the fixing unit (130) when the display apparatus is in the stand mode or the display main body (110) when the display apparatus is in the wall mount mode; and
a plate-shaped supporting part (121) formed to extend from the other end of the pillar part (123) to support a weight of the display main body (110).

4. The display apparatus as claimed in claim 3, wherein the supporting part (121) is disposed in parallel to the lower portion of the display main body (110).

5. The display apparatus as claimed in claim 3, wherein the pillar part (123) includes a first coupling part (125) and a second coupling part (127,129) separately coupled to the fixing unit (130) when the display apparatus is in the stand mode or a portion of the display main body (110) when the display apparatus is in the wall mount mode.

6. The display apparatus as claimed in claim 5, wherein one of the first coupling part (125) and the second coupling part (127,129) has a protrusion shape and the other one of the first coupling part (125) and the second coupling part (127,129) has a groove shape.

7. The display apparatus as claimed in claim 5, wherein the pillar part (123) includes a plurality of first coupling parts (125) and a plurality of second coupling parts (127,129).

8. The display apparatus as claimed in claim 5, wherein the fixing unit (130) or the display main body (110) includes a third coupling part (135) and a fourth coupling part (137,139) to be coupled to the first coupling part (125) and the second coupling part (127,129).

9. The display apparatus as claimed in claim 5, wherein the pillar part (123) is coupled to the display main body (110) by a plurality of fasteners (131a).

10. The display apparatus as claimed in claim 3, wherein the stand unit (120) further includes a first extension part (222,222a) and a second extension part (223,223a) extending from both sides of the supporting part (121), and
the first extension part (222,222a) and the second extension part (223,223a) are bent or curved to collect or reflect the sound output from the sound output unit (150) to a front of the display main body (110) in the wall mount mode.

11. The display apparatus as claimed in claim 1, wherein an upper portion of the stand unit (320a) is rotatably hinge-coupled to the display main body (310a).

12. The display apparatus as claimed in claim 11, wherein the stand unit (320a) is fixed and supported by the fixing unit (330a) in a non-rotation state when the display apparatus is in the stand mode.

13. The display apparatus as claimed in claim 11, further comprising:
a fixing groove (382a) formed in a surface of the pillar part (323a) of the stand unit (320a) ;
an elastic stopper (384a) which gets into and gets out of a surface facing the fixing groove (382a) of the pillar part (323a) of the stand unit (320a) in a lower portion of the display main body (310a) by an elastic member (386a).

14. The display apparatus as claimed in claim 11, wherein the fixing unit (330a) is separably coupled to a lower portion of the rear surface of the display main body (310a) when the display apparatus is in the stand mode, and is separately coupled to an upper portion of the rear surface of the display main body (310a) when the display apparatus is in the wall mount mode.

## Patentansprüche

1. Anzeigevorrichtung, die Folgendes beinhaltet:
einen Anzeigehauptkörper (110);
mindestens eine Tonausgabeeinheit (150), die in einem unteren Abschnitt des Anzeigehauptkörpers (110) angeordnet ist;
eine Befestigungseinheit (130), die trennbar mit einer hinteren Oberfläche des Anzeigehauptkörpers (110) gekoppelt ist, und
eine Ständereinheit (120), wobei die Stellung der Ständereinheit (120) gemäß einem eines Ständermodus und eines Wandhalterungsmodus der Anzeigevorrichtung in Bezug auf den Anzeigehauptkörper (110) veränderbar ist,
wobei die Ständereinheit (120) eingerichtet ist, um den Anzeigehauptkörper (110) in Bezug auf den Boden im Ständermodus zu stützen, und
**dadurch gekennzeichnet, dass**
die Ständereinheit (120) unter der Tonausgabeeinheit (150) angeordnet ist und eingerichtet ist, um nach unten in Richtung einer Vorderseite des Anzeigehauptkörpers (110) geneigt zu werden, um Tonausgabe von der Tonausgabeeinheit (150) zur Vorderseite des Anzeigehauptkörpers (110) im Wandhalterungsmodus zu reflektieren.

2. Anzeigevorrichtung gemäß Anspruch 1, wobei die Ständereinheit mit der Befestigungseinheit gekoppelt ist, wenn sich die Anzeigevorrichtung im Ständermodus befindet, und mit dem Anzeigehauptkörper gekoppelt ist, wenn sich die Anzeigevorrichtung im Wandhalterungsmodus befindet.

3. Anzeigevorrichtung gemäß Anspruch 2, wobei die Ständereinheit (120) Folgendes umfasst: einen Säulenteil (123), von dem ein Ende trennbar mit der Befestigungseinheit (130) gekoppelt ist, wenn sich die Anzeigevorrichtung im Ständermodus befindet, oder mit dem Anzeigehauptkörper (110), wenn sich die Anzeigevorrichtung im Wandhalterungsmodus befindet; und einen plattenförmigen Stützteil (121), der ausgebildet ist, um sich vom anderen Ende des Säulenteils (123) zu erstrecken, um ein Gewicht des Anzeigehauptkörpers (110) zu stützen.

4. Anzeigevorrichtung gemäß Anspruch 3, wobei der Stützteil (121) parallel zum unteren Abschnitt des Anzeigehauptkörpers (110) angeordnet ist.

5. Anzeigevorrichtung gemäß Anspruch 3, wobei der Säulenteil (123) einen ersten Kupplungsteil (125) und einen zweiten Kupplungsteil (127, 129) umfasst, die trennbar mit der Befestigungseinheit (130) gekoppelt sind, wenn sich die Anzeigevorrichtung im Ständermodus befindet, oder mit einem Abschnitt des Anzeigehauptkörpers (110), wenn sich die Anzeigevorrichtung im Wandhalterungsmodus befindet.

6. Anzeigevorrichtung gemäß Anspruch 5, wobei einer des ersten Kupplungsteils (125) und des zweiten Kupplungsteils (127, 129) eine Vorsprungsform aufweist und der andere des ersten Kupplungsteils (125) und des zweiten Kupplungsteils (127, 129) eine Rillenform aufweist.

7. Anzeigevorrichtung gemäß Anspruch 5, wobei der Säulenteil (123) eine Vielzahl von ersten Kupplungsteilen (125) und eine Vielzahl von zweiten Kupplungsteilen (127, 129) umfasst.

8. Anzeigevorrichtung gemäß Anspruch 5, wobei die Befestigungseinheit (130) oder der Anzeigehauptkörper (110) einen dritten Kupplungsteil (135) und einen vierten Kupplungsteil (137, 139) umfasst, um mit dem ersten Kupplungsteil (125) und dem zweiten Kupplungsteil (127, 129) gekoppelt zu werden.

9. Anzeigevorrichtung gemäß Anspruch 5, wobei der Säulenteil (123) mit dem Anzeigehauptkörper (110) mittels einer Vielzahl von Befestigungselementen (131a) gekoppelt ist.

10. Anzeigevorrichtung gemäß Anspruch 3, wobei die Ständereinheit (120) ferner einen ersten Erweiterungsteil (222, 222a) und einen zweiten Erweiterungsteil (223, 223a) umfasst, die sich von beiden Seiten des Stützteils (121) erstrecken, und
wobei der erste Erweiterungsteil (222, 222a) und der zweite Erweiterungsteil (223, 223a) gebogen oder gekrümmt sind, um die Tonausgabe von der Tonausgabeeinheit (150) zu einer Vorderseite des Anzeigehauptkörpers (110) im Wandhalterungsmodus zu sammeln oder reflektieren.

11. Anzeigevorrichtung gemäß Anspruch 1, wobei ein oberer Abschnitt der Ständereinheit (320a) mit dem Anzeigehauptkörper (310a) drehbar gelenkgekoppelt ist.

12. Anzeigevorrichtung gemäß Anspruch 11, wobei die Ständereinheit (320a) mittels der Befestigungseinheit (330a) in einem Nichtdrehungszustand befestigt und gestützt wird, wenn sich die Anzeigevorrichtung im Ständermodus befindet.

13. Anzeigevorrichtung gemäß Anspruch 11, die ferner Folgendes beinhaltet:
eine Befestigungsrille (382a), die in einer Oberfläche des Säulenteils (323a) der Ständereinheit (320a) ausgebildet ist;
einen elastischen Anschlag (384a), der in einem unteren Abschnitt des Anzeigehauptkörpers (310a) mittels eines elastischen Glieds (386a) in eine Oberfläche, die der Befestigungsrille (382a) des Säulenteils (323a) der Ständereinheit (320a) zugewandt ist, hinein und von dieser heraus geht;

14. Anzeigevorrichtung gemäß Anspruch 11, wobei die Befestigungseinheit (330a) trennbar mit einem unteren Abschnitt der hinteren Oberfläche des Anzeigehauptkörpers (310a) gekoppelt ist, wenn sich die Anzeigevorrichtung im Ständermodus befindet, und trennbar mit einem oberen Abschnitt der hinteren Oberfläche des Anzeigehauptkörpers (310a) gekoppelt ist, wenn sich die Anzeigevorrichtung im Wandhalterungsmodus befindet.

## Revendications

1. Appareil d'affichage comprenant :
un corps principal d'afficheur (110) ;
au moins une unité de production de son (150) disposée dans une partie inférieure du corps principal d'afficheur (110) ;
une unité de fixation (130) couplée avec faculté de séparation à une surface arrière du corps principal d'afficheur (110) ; et
une unité de socle (120), la position de l'unité de socle (120) pouvant être changée conformément à l'un d'un mode de montage sur socle et d'un mode de montage mural de l'appareil d'affichage par rapport au corps principal d'afficheur (110),
dans lequel l'unité de socle (120) est agencée pour supporter le corps principal d'afficheur (110) par rapport au sol dans le mode de montage sur socle, et **caractérisé en ce que**,
l'unité de socle (120) est disposée en dessous de l'unité de production de son (150) et agencée pour être inclinée vers le bas vers un devant du corps principal d'afficheur (110) pour réfléchir la sortie de son provenant de l'unité de production de son (150) vers le devant du corps principal d'afficheur (110) dans le mode de montage mural.

2. Appareil d'affichage selon la revendication 1, dans lequel l'unité de socle est couplée à l'unité de fixation quand l'appareil d'affichage est dans le mode de montage sur socle, et est couplée au corps principal d'afficheur quand l'appareil d'affichage est dans le mode de montage mural.

3. Appareil d'affichage selon la revendication 2, dans lequel l'unité de socle (120) comporte :
une pièce de colonne (123) dont une extrémité est couplée avec faculté de séparation à l'unité de fixation (130) quand l'appareil d'affichage est dans le mode de montage sur socle ou au corps principal d'afficheur (110) quand l'appareil d'affichage est dans le mode de montage mural ; et
une pièce de support en forme de plaque (121) formée pour s'étendre depuis l'autre extrémité de la pièce de colonne (123) pour supporter un poids du corps principal d'afficheur (110).

4. Appareil d'affichage selon la revendication 3, dans lequel la pièce de support (121) est disposée parallèlement à la partie inférieure du corps principal d'afficheur (110).

5. Appareil d'affichage selon la revendication 3, dans lequel la pièce de colonne (123) comporte une première pièce d'accouplement (125) et une deuxième pièce d'accouplement (127,129) couplées avec faculté de séparation à l'unité de fixation (130) quand l'appareil d'affichage est dans le mode de montage sur socle ou à une partie du corps principal d'afficheur (110) quand l'appareil d'affichage est dans le mode de montage mural.

6. Appareil d'affichage selon la revendication 5, dans lequel l'une de la première pièce d'accouplement (125) et de la deuxième pièce d'accouplement (127,129) a une forme saillante et l'autre de la première pièce d'accouplement (125) et de la deuxième pièce d'accouplement (127,129) a une forme creuse.

7. Appareil d'affichage selon la revendication 5, dans lequel la pièce de colonne (123) comporte une pluralité de premières pièces d'accouplement (125) et une pluralité de deuxièmes pièces d'accouplement (127,129).

8. Appareil d'affichage selon la revendication 5, dans lequel l'unité de fixation (130) ou le corps principal d'afficheur (110) comporte une troisième pièce d'accouplement (135) et une quatrième pièce d'accouplement (137,139) destinées à être couplées à la première pièce d'accouplement (125) et à la deuxième pièce d'accouplement (127,129).

9. Appareil d'affichage selon la revendication 5, dans lequel la pièce de colonne (123) est couplée au corps principal d'afficheur (110) par une pluralité de fixations (131a).

10. Appareil d'affichage selon la revendication 3, dans lequel l'unité de socle (120) comporte en outre une première pièce de rallonge (222,222a) et une seconde pièce de rallonge (223,223a) s'étendant depuis les deux côtés de la pièce de support (121), et
la première pièce de rallonge (222,222a) et la seconde pièce de rallonge (223,223a) sont fléchies ou courbes pour collecter ou réfléchir le son produit par l'unité de production de son (150) vers un devant du corps principal d'afficheur (110) dans le mode de montage mural.

11. Appareil d'affichage selon la revendication 1, dans lequel une partie supérieure de l'unité de socle (320a) est articulée avec faculté de rotation au corps principal d'afficheur (310a).

12. Appareil d'affichage selon la revendication 11, dans lequel l'unité de socle (320a) est fixée et supportée par l'unité de fixation (330a) dans un état non rotatif quand l'appareil d'affichage est dans le mode de montage sur socle.

13. Appareil d'affichage selon la revendication 11, comprenant en outre :
une rainure de fixation (382a) formée dans une surface de la pièce de colonne (323a) de l'unité de socle (320a) ;
une butée élastique (384a) qui entre et sort d'une surface faisant face à la rainure de fixation (382a) de la pièce de colonne (323a) de l'unité de socle (320a) dans une partie inférieure du corps principal d'afficheur (310a) par un élément élastique (386a).

14. Appareil d'affichage selon la revendication 11, dans lequel l'unité de fixation (330a) est couplée avec faculté de séparation à une partie inférieure de la surface arrière du corps principal d'afficheur (310a) quand l'appareil d'affichage est dans le mode de montage sur socle, et est couplée avec faculté de séparation à une partie supérieure de la surface arrière du corps principal d'afficheur (310a) quand l'appareil d'affichage est dans le mode de montage mural.
